(19) **Europäisches Patentamt / European Patent Office / Office européen des brevets**

(11) **EP 1 785 771 A2**

(12) **EUROPEAN PATENT APPLICATION**

published in accordance with Art. 158(3) EPC

(43) Date of publication:
**16.05.2007 Bulletin 2007/20**

(51) Int Cl.:
*G03F 7/20* (2006.01)    *G03H 1/08* (2006.01)

(21) Application number: **05781066.5**

(22) Date of filing: **05.08.2005**

(86) International application number:
**PCT/RU2005/000404**

(87) International publication number:
**WO 2006/025760 (09.03.2006 Gazette 2006/10)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **20.08.2004  RU 2004125450**

(71) Applicant: **Ivanova, Natalia Viktorovna Moscow, 129164 (RU)**

(72) Inventors:
- **TOLMACHEV, Jurij Aleksandrovich 194021, St. Petersburg (RU)**
- **KERZHENTSEV, Vladimir Vladimirovich 129329, Moscow (RU)**

(74) Representative: **Collier, Ian Terry PO Box 9815 GB-Maldon, Essex CM9 9AX (GB)**

(54) **METHOD FOR PRODUCING AN IMAGE ON A MATERIAL SENSITIVE TO A USED RADIATION, METHOD FOR OBTAINING A BINARY HOLOGRAM (VARIANTS) AND METHODS FOR PRODUCING AN IMAGE BY USING SAID HOLOGRAM**

(57)    The aim of said invention is to principally simplify a production process for producing high-resolution images on a material sensitive to a used radiation and to substantially increase a resolution while forming the obtainable image. The inventive method consists in producing images on the sensitive material in the form of a plurality of summarised areas overlapping flashing exposure spots, wherein the irradiation dose is equal to or greater than a threshold value, in displacing, during exposing, radiator matrixes and/or the sensitive material in a direction parallel to sensitive material surface at a distance which is equal to or less than the maximum size (d) of the exposure spots by discretely modifying the size of the overlapping area, wherein said discrete is defined by a displacement path ranging from 0.01 to d. The method for producing binary holograms consists in placing the sensitive material on the surface of an opaque film, in producing an image thereon by means of said method, in photolithographically forming a plurality of transmission regions in the film, in forming a holographic image on the sensitive material surface with the aid of the binary hologram, in arranging the hologram in such a way that it is possible to perform a step-by-step displacement in a direction perpendicular to the sensitive material at a path ranging from 0.01 nm to $\Delta s$, wherein $\Delta s$ is a variation value of a distance between the material and the binary hologram at which the resolution of the image formed thereby is reduced by 20%.

**Fig. 1**

**Description**

The invention relates to microlithography, in particular to photolithography and can be industrially realized for example in the fabrication of integrated circuits, binary holograms or structures having pre-programmed topography with submicron resolution.

The creation of integrated circuits with characteristic line width of 0.1-0.01 micron is an important and promising direction in the development of up-to-date microelectronics. The high-precision technology (with submicron and micron tolerances) of making precision shapes with three dimensional topography can find industrial application, for example, in the mass production of micro-robotic parts, high resolution elements in diffraction and Fresnel optics and in other technological areas where it is required to obtain a three dimensional image with a predetermined depth and high resolution structures in a functional layer of a device, for example, in the production of printing plates used for making banknotes and other securities.

Further development of microelectronics depends to a great extent on the microlithography process resolution that defines the development level of the majority of current science and technology fields.

Microlithography includes the process of coating the solid body surface (typically a substrate made of a semiconductor material) with a layer of a material sensitive to used radiation flow, including electron beams where most frequently a photoresist layer is used for this purpose. When photoresist is exposed through a so called photomask, usually called a mask, this reproduces on photoresist an image or a pattern of predetermined layout, for example the layout of integrated circuit.

The positioning accuracy in the best projection scanning systems (steppers) manufactured by the world leader in this area of the technological equipment for microelectronics, the Netherlands company ASM-Lithography, is 80 nm, which is clearly not sufficient for creating VLSI ICs with characteristic line width of 20-30 nm. The gap between steppers capabilities and the industry demand is intrinsic because 3-5 years are required to develop steppers for submicron technologies, its cost in mass production is about 10-15 million US dollars, not to mention the development cost amounting hundreds of millions US dollars.

Nowadays, photo-microlithography (or photolithography) is most widely used in the industry. This provides $\Delta x=k_1\lambda/2A$, where $\Delta x$ is the resolution determined by the wavelength of applied radiation $\lambda$ and projection system aperture A. Such a dependence reasonably encouraged developers to use shorter, and even shorter, wavelength radiation sources and larger, and even larger, aperture projection systems. As a result over the last 40 years industrial projection photolithography has moved from mercury lamps with characteristic wavelengths of 330-400 nm to excimer lasers with wavelengths 193 and even 157 nm. The projection lens of modem steppers is up to 600-700 mm in diameter, this has determined fast growth of the cost of steppers.

Unfortunately, the resolution has been increased at the cost of a decreased depth of focus $\Delta F$, since $\Delta F=k_2\lambda/A^2$, this consequently reduces the throughput and makes the focusing system of giant projection lens very complicated, which again increases the stepper cost. Moreover, side effects limit the use of such lens aperture for maximum resolutions provided by the lens.

In the process of projection photolithography development the minimum size of projected parts has been decreasing at an average of 30% each two years, this has allowed a doubling of the number of transistors in an integrated circuit every 18 months (Moore's Law). At present 0.13 micron technology is used in the industry which allows printing parts with a 100nm resolution, meantime, the next milestone according to experts' opinion would be projection systems and radiation sources ensuring reliable resolution at the level of 20-30 nm. This would require extreme ultraviolet (EUV) sources or even soft X-ray radiation. Nowadays there are intensive experiments with microlithography with $\lambda=13.4$ nm. The first such prototype lithography tool was announced at INTEL Developers Forum (Intel is the world leader in the production of VLSI ICs), in 2002 transistors with 50 nanometre lines were printed with this tool. However, the cost of such stepper even at volume production would according to experts be estimated to be around 60 million US dollars and this will require according to the most optimistic estimates 5 - 7 years to master mass production technology for microprocessors with a characteristic 30 nm feature size.

One of the most critical constraints in photolithography is diffraction from the mask edge (diffraction from screen edge) used for projecting the predetermined pattern on the photoresist surface. Due to this effect as you try to increase the monochromatic radiation the image quality degrades because of diffraction maximums located at $\lambda$ distances from the centre of a designed line.

As the leading manufacturers currently use wavelengths $\lambda=193$ nm and even less (in experiments) it becomes apparent how significant the resolution limit caused by edge diffraction on the mask is. Therefore, existing projection devices used to generate patterns on a light sensitive layer have essential drawbacks:

1) significant difficulties of combining high resolution and focus depth in one device;
2) as the wavelength become shorter the design and technology of projection devices used to project patterns onto photoresist surface become far more complicated;

3) as the wavelengths used for projection become shorter the optical system and technology of making mask object become extremely complicated;

4) as the scale integration in the products grows the equipment and technology becomes extremely expensive ;

5) extremely low technological flexibility in the fabrication process and very costly re-adjustment;

6) it is not possible in principle to make diversified manufacturing, i.e. fabrication of various integrated circuits on the same substrate with the same technological process.

There is known a method of producing an image on radiation sensitive material, wherein exposure spots are generated on a material sensitive to used radiation; in which the produced image represents a set of cumulative overlap areas of two or more exposure spots and each exposure spot ensures the radiation dose received by the radiation sensitive material is less than $E_{thresh}$, where $E_{thresh}$ is a radiation dose threshold equal to a sensitivity threshold of the radiation sensitive material. The radiation dose received by the radiation sensitive material in each cumulative overlap area of exposure spot is either equal to or exceeds $E_{thresh}$ (US 6586169 A, published 01.07.2003).

However, the known method of producing an image on the material sensitive to the used radiation does not provide a high resolution image, first of all because there are no exact methods of positioning capable, like in our case, to overlap the areas with a characteristic size of overlap area equal to the area occupied by only one molecular of photoresist as the accuracy of our displacement can be $10^{-2}$ nm. Besides, based on the optical solution used in this method the authors of the patent are limited in terms of minimum overlap area by a value of about half of the wavelength of radiation used to generate exposure spots. Moreover it is not generally possible for them to use the sources of short-wave ultraviolet radiation and soft X-ray radiation, not to mention the bunches of corpuscular particles. Neither the authors accounted for the influence of intensity distribution in exposure spots, which is most likely described by a Bessel function or (at best) a Gaussian function and this causes significant distortion in the pattern generated on the photoresist because there are no special means of pattern correction by adequately accurate positioning of exposure spots relative to each other during their overlay at distances $1 < \lambda$, as in the device proposed by the authors such capability does not exist.

There is known a method of producing a binary hologram, in which a set of transmission areas is generated at a predetermined locations or earlier calculated positions on a film of material which is opaque to used radiation enabling a holographic image to be produced by illuminating the generated set of transmission areas at predetermined distances from these areas (L.M. Soroko " Fundamentals of Holography and Coherent Optics", Moscow, "Nauka" publishers, 1971, p. 420-434). This book studies the capabilities of producing "numeric hologram", also called synthetic, artificial or binary holograms and describes the theory with conciseness and clearness peculiar to mathematic language. However, the known method of producing binary holograms, where the image of transmission areas is generated for example by graphical means and then photographed with significant reduction, does not provide the required high quality image and resolution, primarily because the accuracy and the number of transmission areas are not sufficient.

There is known a method of producing image on a material sensitive to used radiation by hologram, where on the surface of radiation sensitive material exposure spots are generated by imaging at least one hologram set in front of radiation sensitive material (GB 1331076A, published 19.09.1973). However, this known method of producing an image on a material sensitive to used radiation by hologram does not allow for producing high quality images because the set of diffraction orders are mutually overlapping and high resolution is not achievable because it is not possible to use short-wave radiation sources. Moreover, the main objective of that patent was to provide effective control of visually controlled marks.

The technical result that might be obtained due to the proposed invention is a fundamental simplification of the technological process of generating high resolution images on a material sensitive to used radiation as well as a significant increase of resolution in the process of predetermined image generation.

The use of a controlled laser beam (beams) or bunch (bunches) of corpuscular particles and exact positioning proposed by the technology allow producing on radiation sensitive material an image whose size can be compared with the size of a molecule of radiation sensitive material involved in a respective photo-chemical reaction or other process and allows fixing such image, this provides the capability of producing binary holograms with a high-quality image.

Moreover, the proposed technology allows controlling the size of the areas transmitting binary holograms, which provides an additional instrument for controlling the amplitude of elementary diffracting waves and therefore provides extra capability of improving image quality. In this case, the resolution of synthesized binary holograms fully agrees with classical diffraction theory: angular diameter is the ratio of illumination light wavelength or mono-kinetic corpuscular bunch to full hologram size, and consequently, the resolution can be better than the resolution of conventional optical elements.

Thus, there appears the capability of using produced binary holograms for generating patterns on a material sensitive to used radiation, which, in turn, eliminates any focusing or other traditional optical elements for converting wave fronts because in this case only the film with the holes of required size, where the holes are located in a way allowing restore holographic image on a substrate coated with radiation sensitive material, and a source of respective coherent radiation or mono-kinetic bunch of corpuscular particles are required. At the same time, data size contained in the hologram and in the pattern obtained by restored hologram is the same, which enables to determine in advance the required size, structure and the time required to produce the hologram.

In connection with that the proposed technology of producing high resolution patterns allows significantly reduce labour intensiveness compared to all existing types of lithography.

The said technical result is obtained because in a method of producing image on radiation sensitive material on whose surface exposure spots are generated the produced image is composed of a set of cumulative overlap areas of two or more exposure spots, wherein each exposure spot ensures the radiation dose received by the radiation sensitive material is less than $E_{thresh}$, where $E_{thresh}$ is radiation dose threshold equal to a sensitivity threshold of the radiation sensitive material; and wherein the radiation dose received by the radiation sensitive material in each cumulative overlap area of exposure spot is either equal to or exceeds $E_{thresh}$; characterised in that the exposure spots are generated by a two dimensional radiator array located in front of the radiation sensitive material; each radiator is built with the capability of controlling the radiation intensity from this radiator and has at least one element, for example optical, to generate radiation flow with a predetermined size and shape of its cross section, interconnected, for example optically connected to a radiation source; in order to obtain any of cumulative exposure spot overlap areas before exposing at least one exposure spot contained in a cumulative overlap area the radiator array and/or the material sensitive to used radiation are moved parallel to the surface of radiation sensitive material either in the same direction or in two mutually perpendicular directions at a distance not exceeding d, where d is the maximum characteristic size of exposure spots included into given cumulative overlap area and changing the size of overlap areas in a defined direction with a discrete determined by movement pitch from 0.01 nm to d depending on the predetermined size of a given cumulative overlap area.

Moreover, the said technical result is achieved because in a first aspect of a method for producing a binary hologram, in which on a film of material opaque to radiation used for image restoration a set of transmission areas is generated on the basis of predetermined location or earlier calculated position, preliminary the pattern of mentioned set of transmission areas is generated on radiation sensitive material placed on the opaque film; pattern of each transmission area is produced by making cumulative overlap area of exposure spots each of which provides radiation dose on the radiation sensitive material less than $E_{thresh}$, where $E_{thresh}$ is radiation dose threshold equal to a sensitivity threshold of the radiation sensitive material; wherein the radiation dose received by the radiation sensitive material in each cumulative overlap area of exposure spot is either equal to or exceeds $E_{thresh}$; wherein the exposure spots are generated by a two-dimensional radiator array located in front of the radiation sensitive material; each radiator is built with the capability of controlling the radiation intensity from this radiator and has at least one element, for example optical, to generate radiation flow with a predetermined size and shape of its cross section, interconnected, for example optically connected to radiation source; in order to obtain any of cumulative exposure spot overlap area before exposing at least one exposure spot contained in the cumulative overlap area the radiators array and/or radiation sensitive material are moved parallel to the surface of radiation sensitive material either in the same direction or in two mutually perpendicular directions at a distance not exceeding d, where d is the maximum characteristic size of exposure spots included into given cumulative overlap area and changing the size of overlap area in defined direction with a discrete determined by movement pitch from 0.01 nm to d depending on the predetermined size of a given cumulative overlap area; then using some technological processes, for example photolithography followed by etching, predetermined set of transmission areas is generated in the film of material opaque to used radiation.

Both in the method of generating a pattern on the radiation sensitive material and in the first aspect of a method of producing binary hologram when each cumulative overlap area is generated the radiation dose received by radiation sensitive material during the first exposure with the first exposure spot available in given cumulative overlap area, can be from 1/n to 0.95 $E_{thresh}$, where n is the number of repeated exposures during the process of generating cumulative overlap area, where the number of repeated exposures allowing reduce characteristic size D of cumulative overlap area can be set depending on required resolution $\delta$ on produced pattern.

Moreover, when each cumulative overlap area is generated the radiation dose received by the radiation sensitive material with the help of one of exposure spots composing a given cumulative overlap area can be selected to ensure that the radiation dose received by radiation sensitive material during the generation of at least one subsequent exposure spot provides the ratio of radiation pulse time to average relative speed of radiators and radiation sensitive material movement that creates continuous relative step movement of radiators and radiation sensitive material, where the allowed increase $\Delta D$ of characteristic size D of cumulative overlap area due to the movement during exposing radiation pulse does not exceed a predetermined value, for example $\Delta D \leq 10^{-2} D$.

At the same time, when at least one cumulative overlap area is generated the movement pitch can be selected depending on the shape and type of intensity distribution of at least one of the exposure spots that compose a given cumulative overlap area. This enables using parts of the exposure spots corresponding to certain parts of the intensity distribution curve.

On the other hand, when at least one cumulative overlap area is generated the intensity distribution in at least one exposure spot can be formed depending on a predetermined size of given cumulative overlap area, its location on the surface of radiation sensitive material and the distance to at least one adjacent cumulative overlap area. Moreover, intensity distribution in at least one exposure spot can be described for example by Gaussian or Bessel distributions or can be homogeneous.

Both in proposed method of generating pattern on radiation sensitive material and in the first aspect of a method for producing a binary hologram the minimum size of at least one cumulative overlap area may not exceed the value reverse to resolution of radiation sensitive material or even the maximum size of a molecule of radiation sensitive material involved in photo-chemical reaction.

The required size of an exposure spot on the surface of radiation sensitive material can be provided not only by making the radiators with a radiation flow (corpuscular particles) of a predetermined size at their output, but due to the fact that the radiator array is set at predefined distance S from the surface of the radiation sensitive material by step movement of radiator and/or radiation sensitive material in a direction perpendicular to the surface of radiation sensitive material with a pitch ensuring the change of exposure spot characteristic size to a value not exceeding a predetermined value with a minimum discrete size up to 0.01 nm.

Both in the proposed method of generating a pattern on radiation sensitive material and in the first aspect of a method for producing a binary hologram when at least one cumulative overlap area reaches a maximum size not exceeding half of the wavelength of used radiation the advantages of the near-field effect appear, for this purpose the radiator array is used, the diameter $d_1$ of radiation flow from each radiator is from 10 nm to 100 nm and the distance s between radiators array and radiation sensitive material is from 5 nm to $d_1$.

In this case the radiator array can be represented, for example, by a near-field waveguide array connected to at least one radiation source, where the near-field waveguides comprise optical fibres with thinned ends coated with a material which reflects passing radiation and directs it towards the radiation sensitive material. Besides, the radiator array can comprise a waveguide array connected to at least one radiation source, wherein the waveguides are shaped like microcones and are made of a semiconductor material transparent to the used radiation, and the microcones are coated with the layer reflecting passing radiation.

If, while getting maximum size of at least one cumulative overlap area not exceeding half of the radiation wavelength, the radiator array is used with the diameter of the radiation flow from each radiator exceeding the value allowing the use of near-field effect, an aperture array is additionally introduced between the radiator array and the radiation sensitive material, each aperture being coaxial to a respective radiator and generates a diameter $d_1$ of radiation flow from each aperture of 10 nm to 100 nm and sets a distance s between the aperture array and the radiation sensitive material from 5 nm to $d_1$.

The radiator array may be implemented for example by a waveguide array connected to at least one radiation source, each waveguide being directed towards the radiation sensitive material and having an end diameter exceeding the diameter $d_1$, whilst the diameter of the radiation flow coming to a respective aperture does not exceed double the distance from the aperture centre to the edge of any adjacent aperture.

Moreover, in the first implementation of a method of producing a binary hologram it is reasonable that locations of the plurality of transmission areas in the film of opaque material correspond to locations of at least part of the nodes of a square-cell grid. The locations of transmission areas in the film of opaque material and the spacings between them allowing image restoration with a predetermined resolution may be from 5 nm to 100 nm.

The technical result can be also achieved because in the second aspect of the binary hologram implementation method where a plurality of transmission areas having a predetermined or calculated sizes and locations are obtained in a film of material opaque to radiation, which material is used for image recovery, the transmission areas are formed in the opaque film by applying to the above film corpuscular particle beams obtained by using an array of radiators implemented as sources of corpuscular particle beams where the intensity of the corpuscular particle beams can be controlled; the above plurality of the transmission areas are obtained by step movement of the corpuscular particle beam source array and/or the opaque film in one direction or in two mutually perpendicular directions, with a pitch of movement selected between 0.01nm and $d_2$, where $d_2$ is a maximum typical size of formed transmission areas dependent on predetermined sizes of transmission areas and their location on the opaque material surface.

For the array of corpuscular particle beam sources an array of charged corpuscular particle beam sources may be used, such as a field emission emitter array having emitters connected to at least one current source; the above array is placed in a magnetic field directed along the longitudinal axis of each source of charged corpuscular particle beams, for instance along the longitudinal axis of the whisker of every field-emission emitter. It is advisable that the locations of the plurality of the transmission areas in the film of opaque material correspond to the locations of at least part of square-cell grid nodes. The location of the transmission areas in the opaque material film and spacings between them are sized such as to allow recovery of a predetermined image with a required resolution ranged within 5 to 100nm.

Moreover, the technical result is achievable since in the method of image generation in the material sensitive to used radiation by using a hologram where a holographic image is generated on the surface of the material sensitive to used radiation with at least one hologram placed in front of the material sensitive to used radiation, at least one hologram is a binary hologram produced according to the first or second aspect of the binary hologram implementation method including possible particular implementations of the above methods. The binary hologram is placed such as to allow its stepped movement in the direction perpendicular to the surface of the material sensitive to used radiation, with a pitch selected between 0.01 nm and $\Delta S$, where $\Delta S$ is the value of spacing variation between the material sensitive to used radiation and the binary hologram; at this variation the resolution of the image generated by the hologram is reduced by 20% depending on a predetermined alignment accuracy of the image generated by the hologram against the surface of the material sensitive to used radiation, where the accuracy is determined by resolution of the image generated in the radiation sensitive material.

In the case where a plurality of elementary images is to be produced, the number of binary holograms used may be equal to the number of elementary images generated in the material sensitive to used radiation, e.g. to the number of elements formed in one of the IC layers, in which case binary holograms are placed in at least one line; the elementary images are produced in the material sensitive to used radiation where each image is generated by radiation of one of the first diffraction orders resulting from diffraction of radiation on a respective binary hologram; and opaque shields are placed between the binary holograms to shield images generated by radiation of the other diffraction orders.

Moreover, a holographic image can be produced on the surface of the material sensitive to used radiation where the holographic image is a plurality of individual exposure spots each of which ensures receipt by the sensitive material of a radiation dose less than $E_{thresh}$, where $E_{thresh}$ is the radiation dose threshold value corresponding to the sensitivity threshold of the material sensitive to used radiation. Then the hologram and/or the material sensitive to used radiation is moved at least once more in the plane parallel to the radiation sensitive material surface in one direction or in two mutually perpendicular directions to a distance not exceeding $d_3$, where $d_3$ is a maximum typical size of produced exposure spots, thereby creating cumulative exposure spot overlap areas where the radiation dose received by the material sensitive to used radiation is equal to or greater than $E_{thresh}$. When the hologram and/or the material sensitive to used radiation is moved the typical size of the overlap area is changed in predetermined directions with an accuracy determined by the pitch of movement selected in the range of 0.01 nm to $d_3$, depending on a predetermined size of the given overall overlap area.

Fig.1 shows an implementation of the apparatus for pattern generation in a material sensitive to used radiation that has an array of waveguides shaped as microcones.

Fig. 2 shows an implementation of the apparatus for pattern generation in a material sensitive to used radiation that has an array of field-emission emitters.

Fig.3 is an example of overlapped exposure spots area implementation.

Figs. 4 and 5 show curves of equal exposure every 10% from the maximum for an image of 3x5 points when the intensity distribution in an exposure spot is described by Gaussian and Bessel distributions, respectively.

Fig.6 schematically shows shielding of higher diffraction orders when producing an image with a binary hologram.

Fig.7 shows a sample layout of diffraction orders on a substrate used for producing an image.

Fig. 8 is a possible schematic representation of several holograms and produced images.

The proposed method of pattern generation in a material sensitive to used radiation and methods of producing binary holograms can be implemented by using a super-precision magnetostriction nano-positioner (nanostage) to position at least one radiator for creating in the material sensitive to used radiation, preferably photoresist, exposure spots exceeding by their typical size, e.g. the diameter, the achieved line resolution; the positioner being used with photoresist having a threshold effect when a threshold dose is exceeded. Various types of photoresists have a noticeable threshold effect to respective incident radiation. However, this effect is most pronounced in Shipley's high-contrast positive UV5TM POSITIVE DUV photoresists (USA).

The above effect is reached by twofold or multiple positioning of exposure spots on the photoresist surface such that at the first positioning step the photoresist receives a radiation dose that is less than the threshold value $E_{thresh}$, whilst at the second and further positioning steps the exposure spot, firstly, is shifted such that the size of the cumulative exposure spot overlap area during the first and any further positioning is equal to desired resolution and, secondly, the dose imparted to the photoresist in the cumulative overlap area, i.e. at all further positioning steps in the overlap area, together with the dose imparted to the photoresist at the first positioning, exceeds $E_{thresh}$ for the given photoresist. Then the typical size of an area created during further photoresist processing will match the predetermined resolution.

To implement the method of pattern generation in the material sensitive to used radiation and the first implementation of the method for producing binary holograms, various device implementations may be used that provide a predetermined accuracy of relocation of radiators (exposure spots) and/or material sensitive to used radiation in three mutually perpendicular directions as well as predetermined exposure spot sizes.

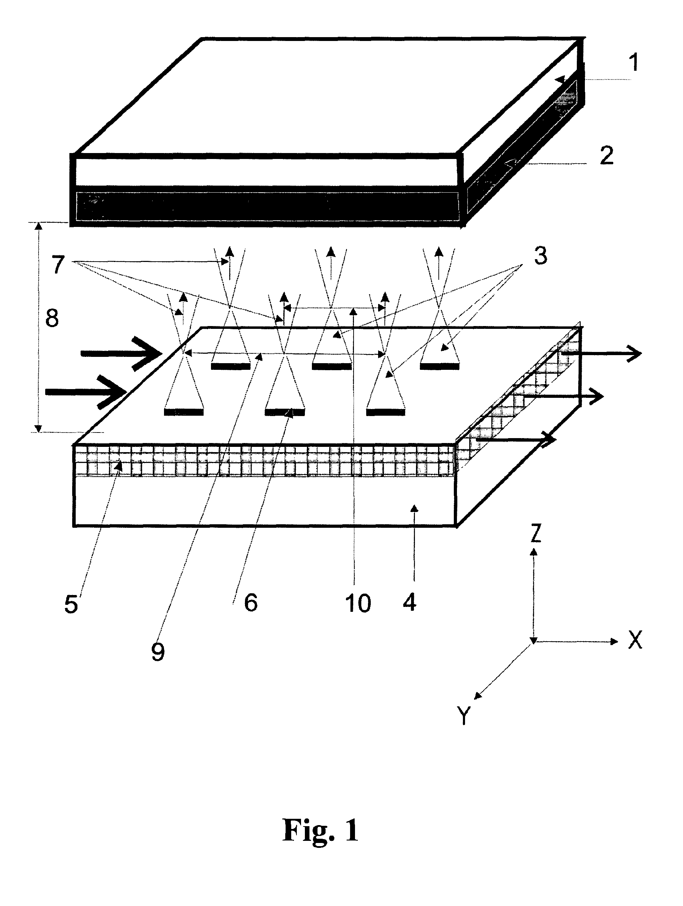

Fig. 1 shows a preferred embodiment of apparatus that can be used for pattern generation in material sensitive to used radiation, e.g. in photoresist, and the first implementation of the method for producing a binary hologram. The apparatus includes a substrate 1 with a photoresist layer 2 coated thereon and a radiator array 3 located on a planar waveguide 5 and placed on a device 4 that is schematically shown in Fig. 1 and used for setting and relocation of this array. The radiator array shown as an example in Fig. 1 is made as an array of waveguides connected to a radiation source or sources (not shown). The waveguides are implemented as microcones made of dielectric or semiconductor material transparent to the used radiation that have an anti-reflective coating and are actually near-field waveguides. They are located on the surface of the planar waveguide 5 which applies radiation to the base of the near-field waveguides implemented as microcones.

At the microcone bases there may be placed individually controllable devices 6 implemented, for instance, as shutters that control radiation access to the microcones. The waveguides may be also implemented as optical fibre waveguides with thinned ends, in which case the individually switchable devices (gates) are provided between the radiation source and the input of a respective waveguide.

The radiation sources can be implemented as nanolasers or light emitting diodes producing preset wavelength radiation and installed in the bases of microcones. In Fig. 1, in compliance with a preferred embodiment of the system, the radiator array 3 is placed in such a way as to ensure movement in three mutually perpendicular directions XYZ (shown by arrows). The pitch value for movement in the XY plane parallel to the photoresist surface is selected in a range 0.01 nm to d, where d is the maximum typical size of the used exposure spots constituting a given cumulative overlap area depending on the predetermined size of the given cumulative overlap area and its location on the surface of material sensitive to used radiation.

For movement in the Z direction, perpendicular to the photoresist surface, the pitch value is determined by a desired exposure spot size, i.e. by a desired diameter of radiation beams 7 used for exposing the photoresist 2 and the accuracy of exposure spot size setting which depends on the distance 8 between the radiation source array and the photoresist.

Moreover, the apparatus can contain, for instance, a waveguide array connected to at least one radiation source and an aperture array placed between them and the radiation sensitive material where each aperture is located coaxially with a respective waveguide and forms a radiation flow diameter $d_1$ at every radiator output. Actually, in such an implementation the aperture array is located at a distance $L \leq d_1$ from the photoresist surface and sets the size of the exposure spot formed on its surface just as a near-field waveguide would do, however in this case the technological implementation of this assembly will be easier.

In another implementation of the method of producing a binary hologram various device implementations can be used to ensure a predetermined accuracy of movement of a corpuscular particle beam source array and/or material opaque to used radiation in three mutually perpendicular directions as well as predetermined cross section sizes.

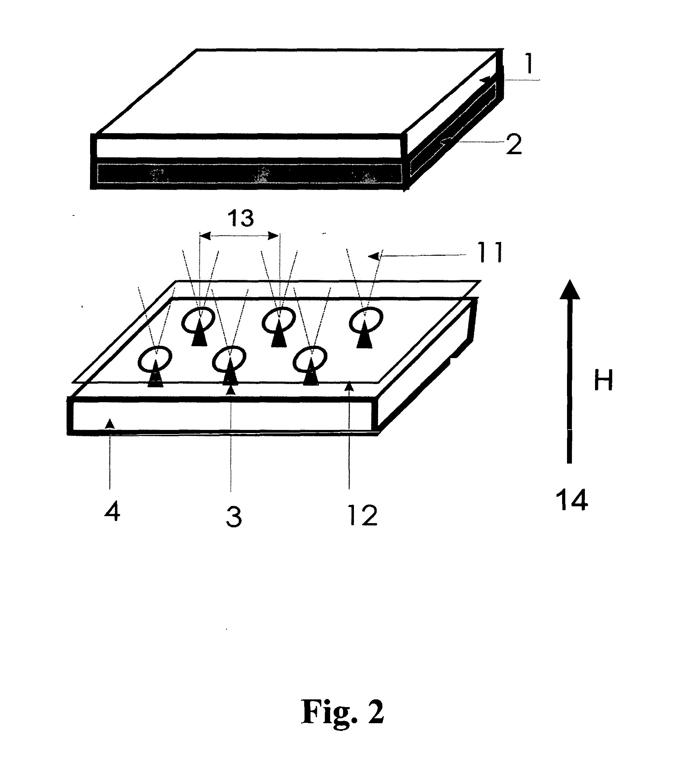

Fig. 2 schematically shows a second implementation of a device that can be used for a binary hologram producing method where the device has a radiator array 3 implemented as an array of sources of corpuscular particle beams, e.g. an array of field-emission emitters, placed on a substrate 4 and emitting electron beams under the effect of the extracting field of the apertures 12. In the film 2 of material opaque to radiation used for image restoration, transmission areas are formed by affecting the film with a beam of corpuscular particles 11 generated by means of the radiator array 3. A plurality of transmission areas is formed by step movement of the corpuscular particle beam source array and/or the opaque material film in a plane parallel to the surface of the opaque material in one direction or in two mutually perpendicular directions. The pitch of movement is selected from a range of 0.01 nm to $d_2$, where $d_2$ is the maximum typical size of transmission areas produced depending on a predetermined size of transmission areas and their locations on the opaque material surface.

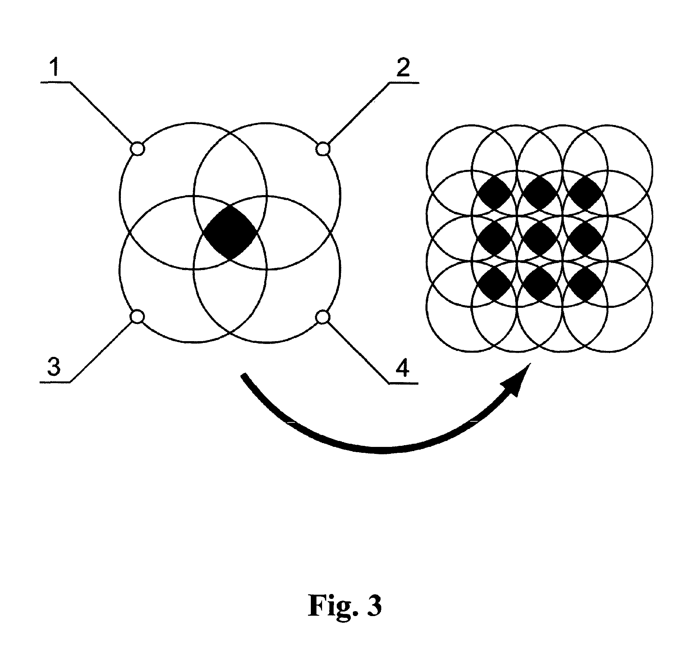

Fig.3 shows a possible implementation of exposure spot overlap areas that is represented as a regular grid with square cells where total exposure spots overlap areas are located in the grid nodes.

It should be noted that though it is possible to obtain relatively uniform intensity distribution in the exposure spots, the actual intensity distribution in the exposure spots does not normally have sharp boundaries. Given the maximum minimization of a displayed point size, this distribution may be approximately described by the Bessel or Gaussian distributions for electron or waveguide beams, or may be accepted as uniform in the first approximation. After simulation of a grid created by superposition of sources with specified intensity distributions it was found that in such cases a regular grid can be obtained too.

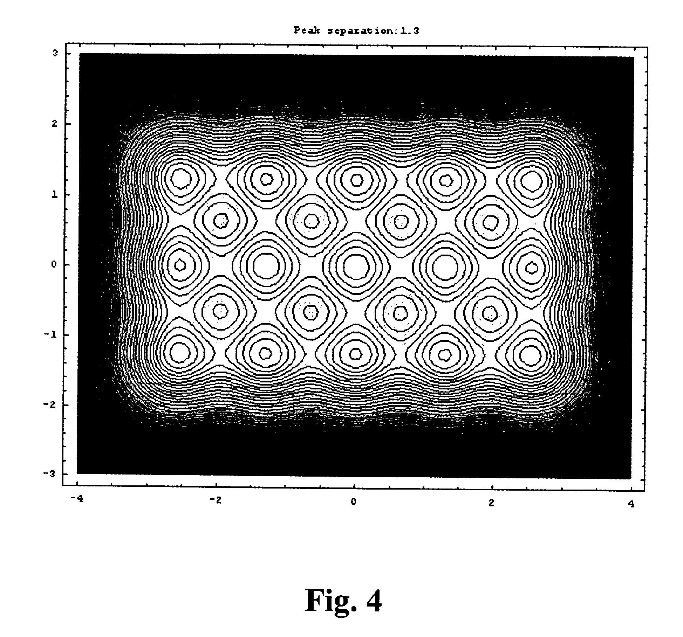

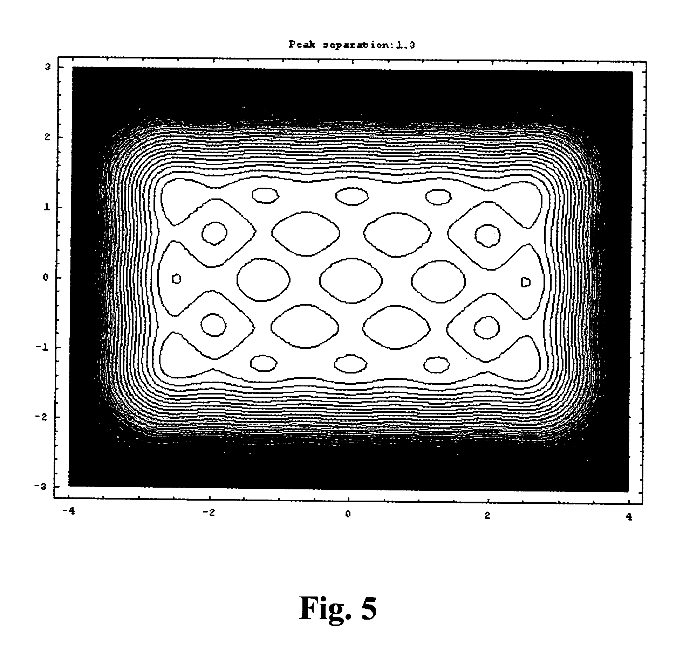

Figs. 4 and 5 represent curves of equal exposure after every 10% of the maximum for a case of a 3x5 point image. The spacing between them is only 30% greater than the absolute minimum value according to Rayleigh resolution criterion. For the Gaussian function that has no subordinate maxima, creation of figures similar in shape to the ones obtained, with beams having sharp boundaries, is obvious. For the Bessel function, a more accurate exposure selection is required. It is clear that due to the square grid clipping during simulation the effect of the subordinate maxima becomes more pronounced resulting in a slightly destroyed symmetry in our example. This is due to a relatively small number of points taken for our estimation (5 points were taken for one axis and 3 points for the other axis). The produced image simply demonstrates that for the Bessel function the role of distant wings is significant, however, after~ 1.5 Rayleigh resolution the effect disappears. The above examples show the necessity of taking the distribution form into account during preliminary calculations as well as the need for accurate selection of a gap between the sources and the irradiated material along with exposure control with an accuracy of 5-10% or better. The examples also show that the configuration of equal exposure areas depends on the form of spatial distribution of radiation intensity in beams. Therefore, to produce cumulative overlap areas the pitch of movement should be selected taking into account the form and type of intensity distribution in exposure spots that create cumulative overlap areas.

On the other hand, in producing cumulative overlap areas it is possible to make or change the intensity distribution in exposure spots with respect to a predetermined size of a given cumulative overlap area, its location on the surface of material sensitive to used radiation and a distance to at least one adjacent cumulative overlap area.

It should be noted than apart from image generation in material sensitive to used radiation by producing individual exposure spots therein, an image may be generated in material sensitive to used radiation by producing an image therein by means of a hologram illuminated by coherent light with a respective wavelength or interacting with a monokinetic beam of corpuscular particles. This means that given a possibility of calculating a hologram of a sufficiently complicated known object (e.g. the hologram of an IC layer layout) as well as a technology of making the hologram using any type of radiation (in particular, electronic, X-ray or hard UV radiation) and sources of space-coherent monochrome radiation or monokinetic charged particle beams needed to restore a respective image on the surface of a layer sensitive to such radiation, such a radiation source may be used for creation of an image of the required compound object by using a pre-calculated binary hologram, and holograms may be used in the process of image generation in material sensitive to used radiation and capable of providing a given resolution.

The IC layers normally do not contain halftone images and all elements are built on binary logic principles "YES-NO", i.e. a given element either exists or is absent in the layer. Therefore, a minimum amount of information is needed for deposition of one layer and in the majority of cases an artificial binary hologram can be used for a respective image generation.

The most popular example of a binary hologram for a point is a Fresnel zone plate. It is capable of focusing a wave into a spot of a size that matches a diffraction resolution limit. Such holograms can operate in a hard UV and soft X-ray ranges and are already used in X-ray microscopes. The fabrication technology of zone plates/holograms does not need powerful coherent light sources of a respective range and is based on physical and chemical processes that are not related to radiation applications. A more complicated hologram is, actually, a sum of Fresnel lenses each of which focuses light into a respective point.

The suggested binary hologram technology is based on the following: equally successful for producing flat optical images are two device types that differ in principle by mode conversion, namely, traditional devices based on using mirrors and lenses and devices based on use of diffraction elements. A special case of the second type devices refers to using holograms produced in a specific way.

The space resolution $\delta$ of both types of devices that represents a point light source is determined by a ratio of a radiation wavelength $\lambda$ (of light or electronic beam) used for image generation to a full crosscut size L of a used device (mirror, lens, hologram). If the lens or hologram is round, then the minimal size of the spot is calculated according to a known formula (see "Physical Encyclopaedia", "Comprehensive Russian Encyclopaedia" publishers, Moscow, 1994, entry "Microscope", V.3, p.141, and "Resolution Capability", v.4, p.248)

$$\delta = 0.61 \frac{\lambda}{\sin\varphi}$$

where $\lambda$ is the wavelength and $\varphi$ is half angle of beam convolution to a point, the sine of this angle is normally about 0.5 (this is the numerical aperture of the lens in microscopy).

Assuming that $tg\varphi = \frac{L}{2s} \cong \sin\varphi$, where L is the typical hologram size, and s is the distance from the hologram to the image created by it. Then

$$\delta = 0.61 \frac{\lambda}{L} 2s = 1.22 \cdot \lambda \frac{s}{L}$$

By determining $\lambda$ from the de Broglie ratio, we obtain $\lambda_B \approx 2,33 \cdot 10^{-1}$ Å for a neutron with 1eV energy. Therefore, given $\delta = 0.1$ nm = 1 Å and a hologram with the L size of 1 cm, we can estimate the distance s between the hologram and the image produced by it equal to:

$$s = \frac{\delta L}{1.22\lambda} = \frac{1 \cdot 1}{1.22 \cdot 2.33 \cdot 10^{-1}} = 3.517 \text{cm}$$

As can be seen from the formula defining the resolution δ, it does not much matter what size the hologram has or what elements the hologram is made of, what really matters is the ratio of the typical (full) size L of the hologram to the distance s between the hologram and the image. The maximum resolution δ is determined by the propagation difference between the beams from the hologram boundary points. Therefore, for instance, in the neutron holography a hologram is written by using an array of detectors each of which is about 1 cm in diameter, and the resolution of such holograms is less than 0.01 nm. (The first zero of the fringe pattern included, according to Rayleigh, into the definition of the resolution capability is produced when Lsinφ = λ/2.)

For halftones simple in quantity, e.g. black-and-white halftones, the number of linearly independent hologram elements (for instance, nodes) should be twice as large as the number of linearly independent image elements since after the hologram the wave amplitude and phase should be set.

In case of monochrome radiation, a hologram, as a focusing device, has the same properties as a compound lens. Moreover, the hologram can produce an image with fewer aberrations than mirror and lens optics. It is possible, for instance, to correct astigmatism simultaneously with the field curvature, which is especially important for producing flat images (L. Soroko "The Fundamentals of Holography and Coherent Optics", "Nauka" publishers, 1971, formula 6.19.7, para. 6.29).

The above described photolithography methods, as mentioned earlier, may be used for fabrication of binary artificial holograms to create, for instance, the layout of a respective IC layer. The simplest binary hologram is a system of identical holes located in the grid nodes in conformity with intensity maxima coordinates of a normal hologram. According to Shannon-Kotelnikov theorem (for its application see J. Goodman "Introduction into Fourier Optics", "Mir" publishers, Moscow, 1970, para. 2.3), hole locations can match nodes of the square-cell grid. It should be noted that the information amount in the hologram coincides with that in an image generated at diffraction. For image halftones simple in quantity, e.g. black-and-white halftones, the number of linearly independent hologram elements should be twice the number of the linearly independent image elements since after the hologram the wave amplitude and phase should be set.

According to the Huygens-Fresnel principle, when a hologram comprised of such holes is illuminated with a flat or spherical wave every hole generates its own half-spherical wave because of diffraction. If the points were located continuously and each of them transmitted a wave with the attenuation factor equal to one, then the hologram would be followed only by a wave transmitted and diffracted at the ends of the entire hologram. According to the calculation, the number and locations of the holes as well as (in the general case) their amplitude and/or phase transmission are made such that diffracted waves formed at a certain distance (about several wavelengths of illuminating radiation) from the hologram can produce a new structurally compound wavefront creating a predetermined image. The existence of the symmetrical grid with holes located at its nodes results in the creation of a wavefront set rather than a single wavefront where the space symmetry of wavefronts is determined by the grid symmetry. There arise so called multiple diffraction orders. Only one of the wavefronts corresponds precisely to the predetermined image, all the rest is referred to as noise and should be suppressed.

The proposed technology makes it possible to control the hole size and configuration, hence there is a tool to control the amplitude of a wave scattered by each hole. This is an additional advantage that makes it possible to improve the image quality and effect the distribution of amplitudes of different diffraction order waves. When doing calculations it should be kept in mind that the amplitude of a diffracted wave strongly depends on the hole diameter (being in squared relationship, if the typical hole size is less than the wavelength). Accordingly, if the hole size is changed unintentionally during fabrication this introduces additional noise (though a slight noise may be useful since it helps to smooth light variations in the vicinity of sharp boundaries)

Discrete holograms, if provided with the afore mentioned additional phase modulation, have an advantage over standard holograms: the mirror image in them with respect to the symmetry axis of the illuminating beam can be suppressed. It is possible to calculate not only the Gabor hologram for the direct beam, as was demonstrated in a number of books and papers and is used in patents, but also the Leith-Upatnieks hologram for oblique beams. (see article "Holography" in "Physical Encyclopedia", "Comprehensive Russian Encyclopedia" publishers, Moscow, V.1, p.598, 1988). This makes it possible to eliminate direct illumination of the image surface by a beam that illuminates the hologram.

When Fourier holograms are used in paraxial approximation the size of the diffraction spot (the point image) should be in full conformity with the classical diffraction theory, namely, the value of the angular diameter corresponds to the ratio of the light radiation wavelength λ to the full typical hologram size L, i.e. (Δφ≈ λ/L).

In overview, we have

1. A practical possibility to calculate a flat hologram of a compound object with a predetermined accuracy, a task that can be solved even on a standard personal computer.

2. A theory that allows calculation of all hologram elements for a radiation of any physical nature.

3. A technology of making holes in a thin film non-transparent for a selected radiation type (e.g. in photoresist or metal foil)

4. Generation of a binary hologram in thin film opaque for selected radiation which in case of corpuscular beams or soft X-rays may be made only after respective photoresist processing, its development and coating with a thin metal layer followed by electrical copying of such a array. In other words, this can be done by using the mask making technology proposed above, in particular, using photon and/or charged particle beams. Therefore, a binary hologram may be made in the form of a thin film opaque for a selected radiation type wherein holes are made by appropriate techniques to be located in nodes of a square-cell grid. The order of hole distribution is calculated beforehand.

5. A technology of accurate displacement of a film of material opaque for used radiation, for instance, metal foil respective a working beam by three coordinates (two coordinates for flat hologram generation, the third one for accurate focusing) making it possible to make appropriately sized holes with predetermined accuracy in required points of the thin film opaque for a selected type radiation.

6. Sources of coherent X-ray or hard UV radiation; sources of charged/neutral particle beams - lasers, synchrotrons; sources of particle beams with particles of sufficiently high monokineticity.

When used in microelectronics, such a technology has a number of advantages:

- an absence of any focusing or other traditional optical elements for wavefront conversion (there is only an opaque film with holes and a coherent radiation source);
- information amounts in the hologram and in the image generated at diffraction are identical, which makes it possible to pre-calculate the needed size of the hologram as well as the time and cost of its fabrication;
- the proposed holographic mask making technology allows control of a hole size thereby providing an additional tool for controlling the amplitude of diffracted elementary waves, which leads to image quality improvement and higher efficiency of using the beam energy to restore an appropriate image by means of the hologram;
- a possibility to suppress an image being the mirror image respective the symmetry axis of the illuminating beam, which enhances the efficiency of using laser energy.

An example of how it can all be done is a diffraction grating concentrating light in one of its orders (up to 70% at a specified polarity) (see "Applied Physical Optics" edited by V. Moskalev, "Politekhnika" publishers, S. Petersburg, 1995, pp.348-349, as well as "Optics" by G. Landsberg, Moscow, "Nauka" publishers, 1976, pp.205-209). Diffraction gratings use continuous wave phase variation within an individual grating groove. Each grating groove has a skewed section profile and acts as an inclined micro-mirror to turn the beam as a whole in a needed direction (a glittering effect of the grating is created under a pre-calculated angle). In this situation under a specified angle not only a shift is formed between individual beams (elementary waves) by one wavelength of radiation analyzed by the grating but also the reflection maximum is present.

In a technology allowing more accurate positioning similar to the one described above, the grating groove profile may be split into several steps with sizes less than the wavelength in which case the same effect can be reached.

In holography the effect of radiation concentration under a specified angle is achieved by an extra phase shift applied within the whole hologram to elementarily small individual areas of a diffracted wavefront selected according to prior estimations. Radiation of a certain diffraction order from various hologram elements into a given point of the image occurs with a shift multiple of $2\pi$, which results in summation of wave amplitudes and enhancement of the image brightness. In the X-ray and UV spectrum this is made possible by using transparent or weakly-absorbing substance that deposited onto an additional layer of the hologram in the hole area. To this end, the hologram itself should be made on a layer transparent, for instance, for X-rays (e.g. on a thin nylon film) with a layer of, for instance, molybdenum deposited thereon. Then this layer is etched and another layer of X-ray transparent substance is deposited at appropriate places with the same technology to ensure local phase shift of radiation used for IC layer fabrication and illuminating the hologram (e.g. for X-raying Cu). In this case the binary hologram fabrication technology becomes more complicated but in principle the method remains quite feasible.

The resolution capability of discrete synthesized holograms (binary holograms) totally conforms to the classical diffraction theory: the angular diameter approximately corresponds to the ratio of an illumination light wavelength to a full typical size of the hologram; therefore in the hard UV or X-ray radiation range the resolution can be higher than that for conventional optical lenses in this wavelength range since the technology of fabricating appropriate optical elements with needed accuracy currently does not exist. Moreover, it will be orders of magnitude less labour intensive than using conventional optics.

The disadvantages of using a similar technology in microelectronics are primarily connected with light loss caused by diffraction, but according to a simple calculation this loss is considerably less than losses of modem "X-ray" or EUV focusing systems. Indeed, a conventional image-producing lens should be mirrored in the UV, EUV or X-ray spectrum ranges and operate at radiation incidence angles close to a normal angle. Such a lens contains not less than 6 mirrors (see C.W. Gwinn, P.J.Silverman «EUV-Lithography. Transition from Research to Commercialization», report on International Conference «Photomask Japan 2003», Pacifico Yokohama, Kanagava, Japan) each of which (in the best case) has a 60% or lower reflection factor. If so, the transmission factor of such a lens will be (at the most optimistic estimate) as low as $(0.6)^6 = 0.046$. Meanwhile, according to L. Soroko's "The Fundamentals of Holography and Coherent Optics", "Nauka" publishers, 1971, (formula 6.19.7., p.423) the diffraction effectiveness of a hologram is about 0.22.

The light loss will be also significantly less than with the use of "X-ray" or EUV focusing systems, particularly if the spacing between holes is comparable with the wavelength (in this case the interference will involve not only far-field waves but also near-field waves and the total effectiveness should increase, as compared with calculations based on classical conceptions). This effect is well known in radio-physics and acoustics when an antenna is made of a dipole set. This technique, in particular, is widely used by radio astronomers when the radio telescope consists of a set of synchronized antennas.

It may be also presumed that fabricating a hologram on a spherical (parabolic) surface contributes to its quality improvement because the combination of the curved surface and zones allows to obtain much lesser deviations from the zero beam propagation difference in a focus on a larger flat surface area (rather than on the axis only). P. Gutman, "Fabrication of Micro-Zone Plates and Evaluation of Their Focusing Properties" in the monograph "X-Ray Optics and Microscopy", Moscow, "Mir" publishers, 1987.

In IC manufacturing each IC layer generally consists of a plurality of elements having an equivalent structure, therefore, it is sufficient for the hologram to have about twice as many points compared to the number of "points" (individual linear elements) the layer is comprised of. (If an IC size is 10x10mm$^2$ and the size of a single element is 10x10nm, then the total number of individual elements is 2. $10^{12}$. Accordingly, the hologram should have the same number of individual elements, e.g. $10^6$x$10^6$ nm.

Use of binary holograms for pattern generation is invariably followed by the following problems:

1) the discretization rate of binary holograms due to the specifics of fabricating transmission areas (holes) located in nodes of a regular grid leads to appearance of multiple images in the highest diffraction orders during image reproduction;
2) the major portion of the external source energy escapes to the "zero' diffraction order that does not possess the space structure of the image;
3) the illumination distribution within a single image varies from the centre towards the edges;
4) the hologram size (with the resolution of the hologram elements identical to the image resolution) turns out to be twice as big as the image itself.

The problem of increasing the energy directed to +1 order of diffraction may be partially solved by using holes having a "compound" contour. According to qualitative results of the theory (see M. Razmanova-Frolenkova, Ju. Tolmachev "The Analysis of Zone Plate and Flat Wave Interaction Using a Pulse Method", Bulletin of SPb State University, ser. 4 "Physics, Chemistry", 2003. Issue 1 (No.4), pp.22-29) as well as the well-known fact (see Z.L.Horvath at al., «Diffraction of short pulses with boundary wave diffraction theory» Phys.Rev. E. 2001, vol. 63, p. 026601-1 - 026601-11.) that diffraction is determined by the amplitude of the boundary wave (i.e. the wave radiated by the hole edge under the effect of an incident wave), the elongation of the hole contour should increase the amplitude of side diffraction orders (particularly, the hole shape produced with the respective technology has a longer contour than the round hole).

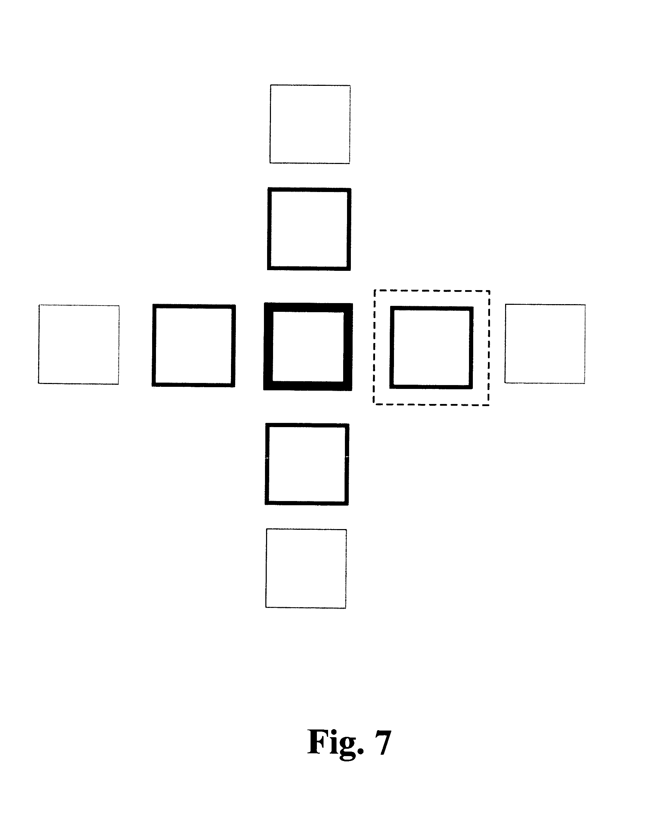

Besides, the problem of the hologram size and the photoresist area exposure technology requires a comprehensive solution. The grid with nodes in which at least part of transmission areas (holes) are located is symmetrical by two coordinates. The result is a two coordinate symmetry in the distribution of diffraction orders (see G. Landsberg, "Optics", Moscow, 1976, pp. 25-227). Fig. 7 shows a sample layout of diffraction orders on a substrate where a pattern is generated (e.g. the layout of a respective IC layer).

The line widths demonstrate brightness reduction of the diffraction orders as the order number increases (not all orders are shown). Only one of the plurality of images turns out to be useful (in Fig. 7 it is outlined by a dashed line). Shielding with shutters makes it possible to leave only one image outlined by a dotted line.

Distribution of illumination within the limits of a system of different order images may be corrected by appropriate calculations of the hologram and by changing (based on the calculations) the size and configuration of the holes. Using a respective technology, it can be done by slightly shifting a pair or one of exposure beams respective the "ideal" grid. This needs a very high positioning accuracy that is provided by nanometre positioners (nano-positioners) used in this invention.

The specific nature of the pattern generation system shown in Fig. 7 which is characteristic of the method of synthetic discrete holography complicates the problem and at the same time simplifies it.

The problem is complicated by the impossibility of simultaneous coverage of a large portion of the substrate area (about 700 cm$^2$) with images because it will result in shifting of diffraction orders from adjacent holograms. On the other hand, the matter can be simplified because if we refuse from the whole substrate exposure we can change the geometry of the hologram by stretching it in the direction from the "zero" order towards the useful image (dotted in Fig. 7) while the resultant resolution remains unchanged. If the hole size in the hologram is equal to the least permissible interval in the image of an IC layer to be formed (and the proposed technology allows a lesser size), then the hologram area required for image generation will be equal to the double area of the IC layer.

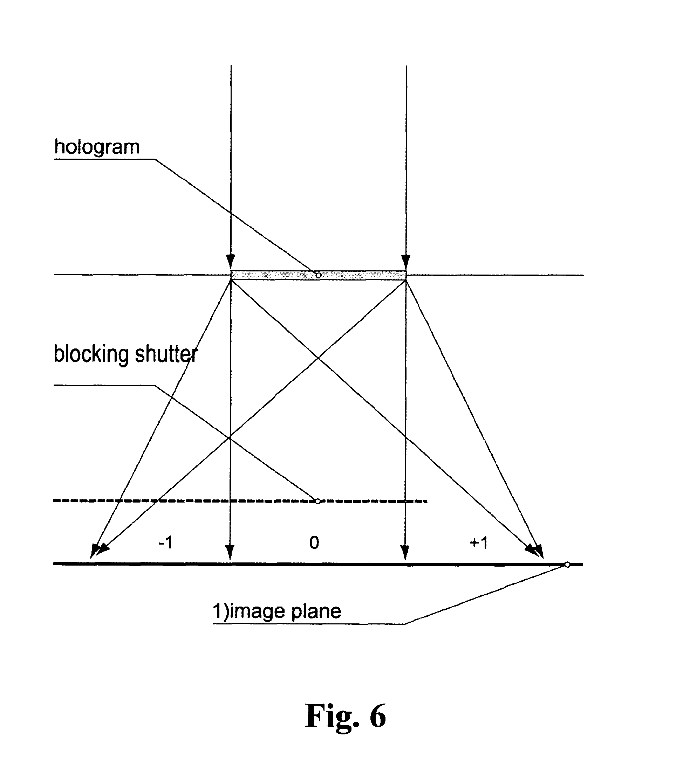

Therefore, the multitude of diffraction orders negates a possibility of simple circuit solutions like getting a square grid at image recovery by means of a square grid of holograms when approximately 1 cm diameter radiation beams are used for producing an IC layer image with a typical size of ~ 1 cm. In this situation the higher orders and the zero order have to be suppressed leaving only the first order, moreover, only "the first" one of those located symmetrically with respect to the axis of the illuminating beam. Fig. 6 is a schematic view of a device for producing an image in material sensitive to used radiation by using a hologram. The device has a shutter shown by a dotted line to block radiations of all diffraction orders save the radiation of one of the first orders.

Assume the image has a square shape, as shown in Fig.7. Let us take one linear dimension of the hologram equal to the side of a square. It is sufficient to make a rectangular hologram by making its second dimension twice as long to provide the needed area.

Since the size of the zero diffraction order strictly corresponds to the hologram size, at such a configuration of the "hologram-image" pair as shown in Fig.7 the size of the latter is three times more than the square side (in particular, if the typical IC size is 1 cm, then the minimum size of the pair, given the same pixel size, is 1x3 cm$^2$). Every hologram has only one image corresponding to it. Every hologram can be illuminated by an individual coherent radiation beam during formation of an IC layer. "Hologram-image" pairs may be placed on the surface in an arbitrary manner. Therefore, a set of different ICs may be built simultaneously on the same substrate.

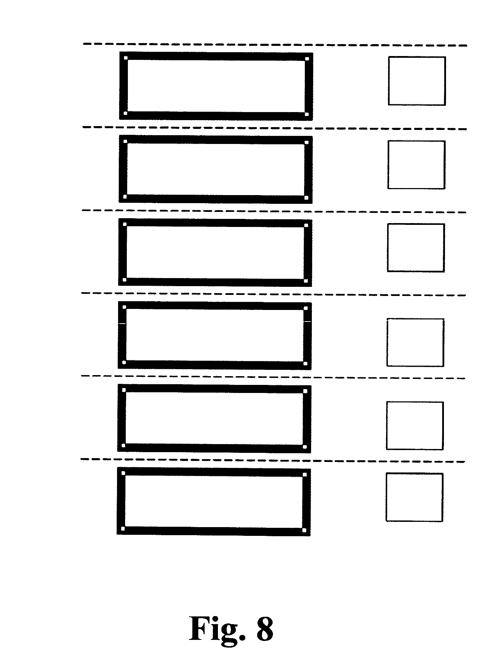

One technologically feasible technique is shown in Fig. 8. Holograms placed closely to each other by their longer sides (with account for technological gaps and widths of shutters absorbing parasitic diffraction orders) create, at a given location of the hologram system, one line of (square-shaped) images. Fig. 8 is the projection of the hologram system and images produced by holograms in a photoresist coated substrate from the side of the incident radiation beam. To create a line of images on a large (as compared to one hologram) substrate, a block of holograms is used (shown in thick print). Images corresponding to each hologram that are formed in the substrate placed under the hologram system are shown by thin lines. The traces of absorbing surfaces of shutters (shields) are shown in Fig.8 by a dotted line. The shutters are placed perpendicularly to the pattern plane to block lateral and zero orders.

The quantity of pairs (hologram + image) may be increased to a required number that is determined by the linear dimensions of the substrate, the chip layer geometry and process spacings. Assuming a substrate diameter of 300 mm and a block (image plus spacings) size of 15 mm, the maximum number of patterns per line will be M=300/15=20. Twenty exposures with the hologram line shifted sequentially in the direction perpendicular to the line are sufficient to cover the total standard-size substrate with required patterns.

The device shown in Fig.8 can be supplemented with hologram lines parallel to the one shown in this figure, which additionally increases the throughput achieved by this method. Parallel image lines placed close to each other make it possible to create on the substrate a system of parallel lines made of the IC layer images. The configuration of the "hologram-image" pair shown in Fig.8 has a width that is three times more than the linear size of the IC layer image. The total number of such lines on the substrate cannot be more than M/3. More realistically, their number will be M/3 - M/4. In the technological process we can at first make, say, line 1-4-7 ...., then 2-5-8 ..., then 3-6-9 ..., etc., shifting the hologram block in the direction perpendicular to the line.

Since the above refers to an area of ~1 cm$^2$ in a respective layer, a minimum of twenty or maximum of thirty shifts should be made on a standard-size substrate at M=20 for writing a single line. If three lines are to be written simultaneously the number of exposures is reduced to 6-7 (with a respective increase of the radiation source energy). With a radiation source normally used in modem steppers (UV of continuous power of 100 W) and the exposure time of 36 s it will take only 360 s (with account for diffraction efficiency) to expose the total area, without taking into account service intervals for line positioning (this should be done with accuracy of up to one permissible interval).

Such a technology can be implemented by using a positioning device that provides sufficiently high positioning accuracy with a shift of ~500 mm on the base.

The solution shown in Fig.8 also makes it possible to increase the resolution at the sake of the throughput. To this end, the area of each hologram is increased K>1 times and may contain K times more discrete elements; the number of simultaneously active holograms is reduced by K times. For instance, by making a square-shaped hologram having the side length two times exceeding the dimensions of the IC layer, we obtain a double increase of individual elements in the hologram; hence the resolution can accordingly be improved by $(2)^{1./2}$ times, as compared to the case considered above. At the same time the number of images in a line is reduce twofold.

Both the hologram and the image may have any shape. The hologram shape is not important and is determined by process requirements. In our situation it is desirable that the pattern of an IC chip layer is a square comprising small elements. The number of elements in the hologram should be at least two times more than the number of elements in the IC chip layer. If the used radiation has a wavelength equal to the minimum resolution, then the hologram area will be twice as large as the chip area. For convenient placement, the hologram width may be taken equal to the width of the square pattern, then (in the ultimate case mentioned) its second dimension will be twice as large, that is why is has been drawn as a rectangle.

A line of holograms (a system of hologram lines) may be fabricated either independently of each other or in a single process cycle. Illumination of the system of lines may be parallel or in a sequence. With development of a technology allowing high-accuracy shifting on a longer base it will be possible to fabricate macro-holograms to produce simultaneously all patterns on a substrate.

The proposed technology may be developed further by combining all elementary holograms into a common hologram that is simultaneously illuminated by a wavefront of hard space-coherent radiation. Such a macro-hologram is capable of producing ALL needed patterns over the ENTIRE substrate. It helps solve the following problems:

- the problem of shielding multiple diffraction orders since the substrate is simply put in a place containing a needed valid image of an IC layer set;
- the problem of line positioning accuracy since the common hologram ensures generation of needed patterns in proper places simultaneously over the whole substrate;
- losses of the substrate space caused by process gaps wasted on shielding and shifting.

The analysis of capabilities of up-to-date positioners for micro-hole making tools shows that only our equipment can provide a required accuracy and throughput on areas of about 1000 $cm^2$ needed to make a hologram capable of one-time exposure of the entire substrate containing seventy images of an integrated circuit layer (layers). No less important in the hole-making technology is a possibility of applying a huge mechanical force in any point of the hologram.

Therefore, holograms are fabricated by lithographic methods using the proposed technology based on joint application of a super-precision magnetostriction XY-nanopositioner (nanostage) to ensure high-accuracy positioning of the radiation source generating in photoresist a spot noticeably exceeding by a typical size (e.g. diameter) the value of achievable linear resolution, on the one hand, and photoresist possessing a threshold effect when a critical dose is exceeded, on the other hand. As a result, a synthesized hologram is obtained being a thin film opaque to a used radiation type that has local transparency zones whose sizes and locations are set beforehand. To make it more robust, it can be placed onto a durable transparent substrate (e.g. nylon, if an electron beam is used). At every zone, being several nanometres to several dozens of nanometres in size, a used type of short-wave radiation (a monokinetic beam of corpuscular particles) will diffract generating an image of a respective IC layer.

Further enhancement of the technology and improvement of the image quality can be achieved by jointly using advantages of making patterns in photoresist in the form of a plurality of overlapping exposure spots and in the form of a holographic image. The holographic image produced on the surface of material sensitive to used radiation is a plurality of discrete exposure spots where each exposure spot provides receiving by the sensitive material of a radiation dose less than $E_{thresh}$, where $E_{thresh}$ is the threshold value of the radiation dose that corresponds to the sensitivity threshold of the material sensitive to used radiation. Then the hologram and/or the material sensitive to used radiation are moved at least once more towards the used radiation source in the plane parallel to the surface of the material sensitive to used radiation in a single direction or in two mutually perpendicular directions to a distance not exceeding $d_3$, where $d_3$ is the maximum characteristic size of the overlap area, to form cumulative areas of exposure spots in which the radiation dose received by the radiation sensitive material is equal to or greater than $E_{thresh}$; by such movement of the hologram and/or the material sensitive to used radiation the typical size of the overlap area is changed in the above-mentioned directions with an accuracy determined by the pitch of movement which is selected in the range of 0.01 nm to $d_3$, depending on a predetermined size of the given cumulative overlap area.

In summary, using the proposed methods simplifies the technological process of high-resolution pattern generation in material sensitive to used radiation as well as considerably improves resolution of pattern generation making it possible to produce patterns with sizes comparable to that of a molecule of material sensitive to used radiation.

**Claims**

1. A method of generating a pattern in a material sensitive to used radiation, wherein exposure spots are generated on the surface of radiation sensitive material and the pattern represents a set of cumulative overlap areas of two or more exposure spots, wherein each exposure spot ensures a radiation dose received by radiation sensitive material less than $E_{thresh}$, where $E_{thresh}$ is radiation dose threshold equal to sensitivity threshold of radiation sensitive material; and wherein the radiation dose received by radiation sensitive material in each cumulative overlap area of exposure spot is either equal to or exceeds $E_{thresh}$, **characterised in that** exposure spots are generated by a two-dimensional radiator array located in front of the radiation sensitive material; each radiator is built with the capability of controlling the radiation intensity from this radiator and has at least one element to generate radiation flow with predetermined size and shape of its cross section, connected to radiation source; while generating any cumulative exposure spot overlap area before exposure of at least one exposure spot comprising cumulative overlap area the radiators array and/or the material sensitive to used radiation are moved parallel to the surface of radiation sensitive material either in the same direction or in two mutually perpendicular directions at a distance not exceeding d, where d is maximum characteristic size of exposure spots composing given cumulative overlap area, changing the size of overlap area in defined directions with a discrete determined by the movement pitch from 0.01 nm to d depending on the predetermined size of a given cumulative overlap area.

2. The method according to Claim 1, wherein in the process of generating each cumulative overlap area a radiation dose received by radiation sensitive material during the fist exposure with the first exposure spot composing given cumulative overlap area is from 1/n to 0.95 $E_{thresh}$, where n is the number of repeated exposures during generation of cumulative overlap area; the number of repeated exposures allowing to reduce characteristic size D of cumulative overlap area is determined depending on required resolution $\delta$ of the pattern generated.

3. The method according to Claim 1, wherein in the process of each cumulative overlap area generation the radiation dose received by radiation sensitive material with the help of one of exposure spots composing given cumulative overlap area is selected in a way that radiation dose received by radiation sensitive material during the generation of at least one subsequent exposure spot provides such a ratio of radiation pulse time to average relative speed of radiators and radiation sensitive material that allows using continuous relative step movement of radiators and radiation sensitive material, where the allowed increase $\Delta D$ of characteristic size D of cumulative overlap area due to the movement during exposing radiation pulse does not exceed a predetermined value, for example $\Delta D \leq 10^{-2}$ D.

4. The method according to Claim 1, wherein while at least one cumulative overlap area is being generated the movement pitch is selected depending on the shape and type on intensity distribution in at least one of exposure spots composing the given cumulative overlap area.

5. The method according to Claim 1, wherein while at least one cumulative overlap area is being generated intensity distribution in at least one exposure spot is formed depending on predetermined size of the given cumulative overlap area, its location on the surface of radiation sensitive material and distance to at least one adjacent cumulative overlap area.

6. The method according to Claim 4 or Claim 5, wherein an intensity distribution in at least one exposure spot is described by Gaussian or Bessel distributions or homogeneous.

7. The method according to Claim 1, wherein a characteristic size of at least one cumulative overlap area does not exceed the value reverse to resolution of radiation sensitive material.

8. The method according to Claim 1, wherein the minimum size of at least one cumulative overlap area does not exceed the maximum size of a molecule of radiation sensitive material involved in photo-chemical reaction.

9. The method according to Claim 1, wherein a required size of the exposure spot on the surface of the material sensitive to used radiation is provided by setting radiators array at predefined distance s from the surface of radiation sensitive material by step movement of radiators and/or radiation sensitive material in the direction perpendicular to the surface of radiation sensitive material with a pitch ensuring the change of exposure spot characteristic size to the value not exceeding a predetermined value with minimum discrete up to 0.01 nm.

10. The method according to any one of Claims 1-5 and 7-9, wherein when at least one cumulative overlap area reaches the maximum size not exceeding half of used optical radiation wavelength, the radiators array is used, meantime, the diameter $d_1$ of radiation flow from each radiator is from 10 nm to 100 nm and the distance s between radiators array and radiation sensitive material is from 5 nm to $d_1$.

11. The method according to Claim 10, wherein the radiator array comprises a near-field waveguide array connected to at least one radiation source and near-field waveguides are made of fibre optics with thinned ends coated with a material reflecting passing radiation and directed towards radiation sensitive material.

12. The method according to Claim 10, wherein the radiator array comprises a waveguide array connected to at least one radiation source; the waveguides being shaped like microcones and made of semiconductor material transparent to the used radiation, and the microcones are coated with the layer reflecting passing radiation.

13. The method according to any one of Claims 1-5 and 7-9, wherein while getting the maximum size of at least one cumulative overlap area not exceeding half of used optical radiation wavelength, an aperture array is provided between the radiator array and the radiation sensitive material, wherein each aperture is coaxial to a respective radiator and generates a diameter $d_1$ of radiation flow from each aperture in the range from 10 nm to 100 nm and the distance s between the aperture array and radiation sensitive material is from 5 nm to $d_1$.

14. The method according to Claim 13, wherein the radiator array comprises a waveguide array connected to at least one radiation source, each waveguide being directed towards the radiation sensitive material and having an end diameter exceeding diameter $d_1$, at the same time, the diameter of a radiation flow coming to a respective aperture does not exceed double distance from this aperture centre to the edge of any adjacent aperture.

15. A method of producing binary hologram, in which on a film of a material opaque to radiation used for image restoration a set of transmission areas is generated according to a predetermined location or preset position, wherein the pattern of transmission areas set is preliminary generated in radiation sensitive material placed on opaque film; the pattern of each transmission area is obtained by producing a cumulative overlap area of exposure spots each of which provides a radiation dose on radiation sensitive material less than $E_{thresh}$, where $E_{thresh}$ is the radiation dose threshold equal to the radiation sensitive material sensitivity threshold; the radiation dose received by radiation sensitive material in each cumulative overlap area of exposure spots is either equal to or exceeds $E_{thresh}$; wherein exposure spots are generated by two-dimensional radiators array located in front of the radiation sensitive material; each radiator is built with the capability of controlling the radiation intensity from this radiator and has at least one element to generate radiation flow of a predetermined size and shape of its cross section and connected to radiation source; in the process of generating any cumulative exposure spot overlap area before exposure of at least one exposure spot comprising cumulative overlap area the radiator array and/or the material sensitive to used radiation are moved parallel to the surface of radiation sensitive material either in the same direction or in two mutually perpendicular directions to a distance not exceeding d, where d is the maximum characteristic size of exposure spots composing the given cumulative overlap area and changing the size of the overlap area in defined direction with a discrete determined by a movement pitch from 0.01 nm to d, depending on the predetermined size of the given cumulative overlap area; then using some technological processes predetermined set of transmission areas is generated in the film of material opaque to the used radiation.

16. The method according to Claim 15, wherein the location of transmission areas set in the film of opaque material corresponds to the location of at least some parts of grid nodes with square cells.

17. The method according to Claim 15, wherein the resolution of restored holographic image is from 5 nm to 100 nm.

18. The method according to Claim 15, wherein the location of transmission areas in the film of opaque material and the distances between them allowing restore predetermined image with required resolution.

19. The method according to Claim 15, wherein in the process of generating each cumulative overlap area radiation dose received by radiation sensitive material during the fist exposure with the first exposure spot composing the given cumulative overlap area is from 1/n to 0.95 $E_{thresh}$, where n is the number of repeated exposures in the process of cumulative overlap area generation, and the number of repeated exposures allowing reduce characteristic size D of cumulative overlap area is determined depending on required resolution $\delta$ on the pattern generated.

20. The method according to Claim 15, wherein in the process of generating each cumulative overlap area the radiation dose received by radiation sensitive material with one of exposure spots comprising the given cumulative overlap area is selected in a way that the radiation dose received by radiation sensitive material during the generation of at least one subsequent exposure spot provides such a ratio of radiation pulse time to average relative speed of radiators and radiation sensitive material that allows using continuous relative step movement of the radiators and radiation sensitive material, where the allowed increase $\Delta D$ of characteristic size D of cumulative overlap area due to the movement during exposing radiation pulse does not exceed predetermined value, for example $\Delta D \leq 10^{-2}$ D.

21. The method according to Claim 15, wherein in the process of generating at least one cumulative overlap area the movement pitch is selected depending on the shape and type of intensity distribution in at least one of exposure spots comprising the given cumulative overlap area.

22. The method according to Claim 15, wherein in the process of generating at least one cumulative overlap area intensity distribution in at least one of exposure spots is formed depending on predetermined size of the given cumulative overlap area, its location on the surface of the material sensitive to used radiation and distance to at least one adjacent cumulative overlap area.

23. The method according to Claim 21 or Claim 22, wherein an intensity distribution in at least one of exposure spots is described by a Gaussian or Bessel distribution or is homogeneous.

24. The method according to Claim 23, wherein characteristic size of at least one cumulative overlap area does not exceed the value reverse to resolution of radiation sensitive material.

25. The method according to Claim 15, wherein the minimum size of at least one cumulative overlap area does not exceed the maximum size of a molecule of radiation sensitive material involved in photo-chemical reaction.

26. The method according to Claim 15, wherein required size of exposure spot on the surface of the material sensitive to used radiation is provided by setting radiators array at pre-defined distance s from the surface of radiation sensitive material by step movement of radiators and/or radiation sensitive material in the direction perpendicular to the surface of radiation sensitive material with a pitch ensuring the change of exposure spot characteristic size to the value not exceeding predetermined value with minimum discrete up to 0.01 nm.

27. The method according to any one of Claims 15-22 and 24-26, wherein when at least one cumulative overlap area reaches the maximum size not exceeding half of used optical radiation wavelength, the radiators array is used, meantime, the diameter $d_1$ of radiation flow from each radiator is from 10 nm to 100 nm and the distance s between radiators array and radiation sensitive material is from 5 nm to $d_1$.

28. The method according to Claim 27, wherein the radiator array comprises a near-field waveguide array connected to at least one radiation source and the near-field waveguides being made of fibre optics with thinned ends coated with a material reflecting passing radiation and directed towards radiation sensitive material.

29. The method according to Claim 27, wherein the radiator array comprises a waveguide array connected to at least one radiation source; the waveguides being shaped like microcones made of semiconductor material transparent to used radiation, and the microcones are coated with the layer reflecting passing radiation.

30. The method according to any one of Claims 15-22 and Claims 24-26, wherein while getting maximum size of at least one cumulative overlap area not exceeding half of used optical radiation wavelength, an aperture array is provided between the radiator array and the radiation sensitive material, each aperture being coaxial to respective radiator and generates diameter $d_1$ of radiation flow from each aperture in the range from 10 nm to 100 nm and the distance s between aperture array and radiation sensitive material is from 5 nm to $d_1$.

31. The method according to Claim 30, wherein the radiator array comprises a waveguide array connected to at least one radiation source; each waveguide being directed towards the radiation sensitive material and having an end diameter exceeding diameter $d_1$, at the same time, the diameter of radiation flow coming to a respective aperture does not exceed doubled distance from this aperture centre to the edge of any adjacent aperture.

32. A method of producing binary hologram, wherein on a film of a material opaque to radiation used for image restoration a set of transmission areas is generated according to predetermined location or preset position, wherein the transmission areas are generated in the film of opaque material by sending a bunch of corpuscular particles to the said film; corpuscular particles being generated by a radiator array built as the sources of corpuscular particle bunches with the capability of controlling the intensity of corpuscular particle bunches from these sources; the said set of transmission area is generated by step movement of corpuscular particle bunch sources array and /or the film of opaque material parallel to the surface of opaque material either in the same direction or in two mutually perpendicular directions with the pitch from 0.01 nm to $d_2$, where $d_2$ is maximum characteristic size of generated transmission areas depending on predetermined size of transmission areas and their position on the surface of opaque material.

33. The method according to Claim 32, wherein corpuscular particle bunch sources array comprises charged corpuscular particle beam sources array, for example field emission emitters array placed in magnetic field along longitudinal axis of each source of charged corpuscular particle beam, for example along longitudinal axis of a whisker of each field emission emitter

34. The method according to Claim 32, wherein diameter $d_1$ of radiation flow from each source of corpuscular particle beams is from 5 nm to 100 nm.

35. The method according to Claim 32, wherein the location of transmission areas set in the film of opaque material corresponds to the location of at least some parts of grid nodes with square cells.

36. The method according to Claim 32, wherein the resolution of restored holographic image is from 5 nm to 100 nm.

37. The method according to Claim 3, wherein the location of transmission areas in the film of opaque material and the distances between them allow restore predetermined image with required resolution.

38. A method of producing image on radiation sensitive material with a hologram; the holographic image being generated on the surface of radiation sensitive material with the help of at least one hologram set in front of radiation sensitive material, wherein at least one hologram is represented by binary hologram produced according to Claims 15-31 or 32-37 and located with the capability of moving step-by-step in the direction perpendicular to the surface of radiation sensitive material with a pitch from 0.01 nm to $\Delta$s, where $\Delta$s is a change of distance between radiation sensitive material and binary hologram at which resolution of the image generated by hologram is reduced by 20% depending on predetermined alignment accuracy of image generated by hologram and the surface of radiation sensitive material; the accuracy is determined by resolution of the image produced on radiation sensitive material.

39. The method according to Claim 38, wherein the number of binary holograms is equal to the number of elementary patterns, generated on radiation sensitive material, for example the number of elements in one of integrated circuit's layer and binary holograms are placed in the form of at least one line; elementary patterns being generated in the radiation sensitive material, each of them being generated by one of the first-order diffraction radiation, resulting from radiation diffraction on respective binary hologram; opaque screens capable of screening the patterns generated by other-order diffraction radiation are mounted between binary holograms.

40. The method according to Claim 38, wherein holographic image is produced on the surface of radiation sensitive material; holographic image represents a set of discrete exposure spots, where each exposure spot ensures that the radiation dose received by radiation sensitive material less than $E_{thresh}$, where $E_{thresh}$ is radiation dose threshold equal to sensitivity threshold of radiation sensitive material; then at least one time the hologram or/and radiation sensitive material are additionally moved parallel to radiation sensitive material either in the same direction or in two mutually perpendicular directions to the distance not exceeding $d_3$, where $d_3$ is maximum characteristic size of generated exposure spots, thus forming cumulative overlap areas of exposure spots, where radiation dose received by radiation sensitive material is either equal to or exceeds $E_{thresh}$; when holograms or/and radiation sensitive material are moved the characteristic size of overlap area in defined direction is changed at accuracy determined by movement pitch from 0.01 nm to $d_3$ depending on predetermined size of given cumulative overlap area.

**Fig. 1**

**Fig. 2**

**Fig. 3**

Peak separation:1.3

## Fig. 4

Fig. 5

hologram

blocking shutter

-1    0    +1

1)image plane

# Fig. 6

**Fig. 7**

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6586169 A

- GB 1331076 A

**Non-patent literature cited in the description**

- **L.M. SOROKO.** Fundamentals of Holography and Coherent Optics. Nauka, 1971, 420-434
- Microscope. Physical Encyclopaedia. Comprehensive Russian Encyclopaedia, 1994, vol. 3, 141
- **L. SOROKO.** The Fundamentals of Holography and Coherent Optics. Nauka, 1971
- **J. GOODMAN.** *Introduction into Fourier Optics,* 1970
- Holography. Physical Encyclopedia. Comprehensive Russian Encyclopedia, 1988, vol. 1, 598
- Applied Physical Optics. Politekhnika, 1995, 348-349
- Optics. Nauka, 1976, 205-209
- EUV-Lithography. Transition from Research to Commercialization. **C.W. GWINN ; P.J.SILVERMAN.** Photomask Japan 2003. Pacifico Yokohama

- **L. SOROKO'S.** The Fundamentals of Holography and Coherent Optics. Nauka, 1971, 423
- Fabrication of Micro-Zone Plates and Evaluation of Their Focusing Properties. **P. GUTMAN.** X-Ray Optics and Microscopy. Mir, 1987
- The Analysis of Zone Plate and Flat Wave Interaction Using a Pulse Method. **M. RAZMANOVA-FROLENKOVA ; JU. TOLMACHEV.** Physics, Chemistry. 2003, 22-29
- Diffraction of short pulses with boundary wave diffraction theory. **Z.L.HORVATH.** Phys.Rev. E. 2001, vol. 63
- **G. LANDSBERG.** Optics. 1976, 25-227